# EUROPEAN PATENT SPECIFICATION

(11) **EP 3 451 281 B1**
(45) Date of publication and mention of the grant of the patent: **06.04.2022**
(21) Application number: 16900570.9
(22) Date of filing: 12.05.2016
(51) Int. Cl.: G06T 5/20, G01R 33/561

(54) **THREE-DIMENSIONAL PARALLEL IMAGE RECONSTRUCTION SCHEME USING BOOMERANG-SHAPED KERNEL**
PARALLELES DREIDIMENSIONALES BILDREKONSTRUKTIONSSCHEMA MIT EINEM BUMERANGFÖRMIGEN KERN
SCHÉMA DE RECONSTRUCTION D'IMAGE PARALLÈLE TRIDIMENSIONNELLE À L'AIDE D'UN NOYAU EN FORME DE BOOMERANG

(30) Priority: 29.04.2016 KR 20160053559
(43) Date of publication of application: 06.03.2019
(73) Proprietor: Gil Medical Center, Incheon 21565 (KR); Gachon University of Industry-Academic Cooperation Foundation, Seongnam-si, Gyeonggi-do 13120 (KR)
(72) Inventor: CHUNG, Jun Young, Incheon 22760 (KR); HAN, Ye Ji, Seoul 07670 (KR); SONG, Jung Hyun, Incheon 21557 (KR); SHIN, Seon Young, Hwaseong-si Gyeonggi-do 18340 (KR)
(74) Representative: Müller Schupfner & Partner Patent- und Rechtsanwaltspartnerschaft mbB
(86) International application number: PCT/KR2016/004967
(87) International publication number: WO 2017/188496

(56) References cited:
- KR-B1- 101 517 606
- US-A1- 2008 242 972
- US-A1- 2013 076 352
- US-A1- 2013 279 781
- US-B1- 8 644 578
- SONG ET AL: "Effects of ACS line geometry in volumetric GRAPPA: A comparative study", INTERNATIONAL SOCIETY FOR MAGNETIC RESONANCE IN MEDICINE, ISMRM, 2030 ADDISON STREET, 7TH FLOOR, BERKELEY, CA 94704 USA, no. 3217, 22 April 2016 (2016-04-22), pages 1-2, XP040684258,
- MIAO JUN ET AL: "K-space reconstruction with anisotropic kernel support (KARAOKE) for ultrafast partially parallel imaging", MEDICAL PHYSICS, AIP, MELVILLE, NY, US, vol. 38, no. 11, 1 November 2011 (2011-11-01), pages 6138-6142, XP012151979, ISSN: 0094-2405, DOI: 10.1118/1.3651693 [retrieved on 2011-10-24]
- MIAO JUN ET AL: "Modeling non-stationarity of kernel weights for k-space reconstruction in partially parallel imaging", MEDICAL PHYSICS, AIP, MELVILLE, NY, US, vol. 38, no. 8, 29 July 2011 (2011-07-29), pages 4760-4773, XP012145428, ISSN: 0094-2405, DOI: 10.1118/1.3611075
- ANAGHA DESHMANE ET AL: "Parallel MR imaging", JOURNAL OF MAGNETIC RESONANCE IMAGING, vol. 36, no. 1, 13 June 2012 (2012-06-13), pages 55-72, XP55546603, US ISSN: 1053-1807, DOI: 10.1002/jmri.23639

## Description

### [Technical Field]

The present disclosure relates to an image reconstruction technique used in magnetic resonance imaging (MRI), and more particularly, to a three-dimensional parallel image reconstruction technique using a boomerang-shaped kernel.

### [Background Art]

The three-dimensional generalized autocalibrating partially parallel acquisition (3D-GRAPPA), which is a three-dimensional parallel image reconstruction technique of the currently available image reconstruction techniques for acquiring MRI images, generally involves: an MRI scanning process for acquiring MRI scanning data, a data estimation process for estimating and filling missing data present in the MRI scanning data, and an image restoration process of Fourier-transforming the MRI scanning data after the missing data estimation to restore the MRI scanning data into an MRI image.

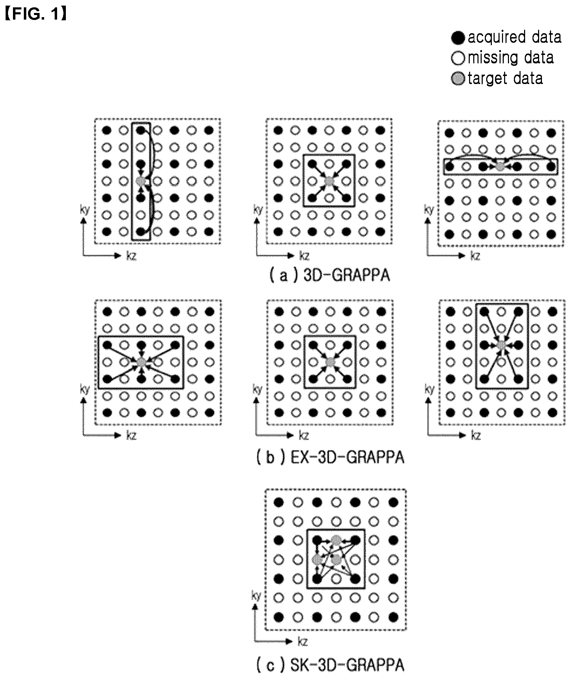

FIG. 1 is a view conceptually illustrating 3D-GRAPPA, extended 3D-GRAPPA (EX-3D-GRAPPA), and single-kernel 3D-GRAPPA (SK-3D-GRAPPA) as examples of three-dimensional parallel image reconstruction techniques according to the conventional technology.

Unlike 3D-GRAPPA shown in FIG. 1A and EX-3D-GRAPPA shown in FIG. 1B, which use three kernels, the single-kernel 3D-GRAPPA (SK-3D-GRAPPA) shown in FIG. 1C uses only one kernel.

Such SK-3D-GRAPPA uses only one kernel, but is able to fill the same number of missing data as the number of missing data filled one time by three kernels in 3D-GRAPPA and EX-3D-GRAPPA. Therefore, according to SK-3D-GRAPPA, it is confirmed that the computational speed is significantly improved compared to the previous 3D-GRAPPA and EX-3D-GRAPPA.

However, SK-3D-GRAPPA can have a disadvantage that the performance is rather deteriorated in terms of image quality as compared with the previous 3D-GRAPPA and EX-3D-GRAPPA.

(Patent Document 1) Korean Patent Publication No. 1517606 (April 28, 2015)

J.H. SONG et al. "Effects of ACS line geometry in volumetric GRAPPA: A comparative study", Proc. Intl. Soc. Mag. Reson. Med. 24(2016), pages 1-2 use auto-calibration signal (ACS) lines in order to determine a weighting factor of the acquired data to be used for estimation. In particular, the ACS lines are obtained so that the aspect ratio of the ACS lines in the K_{z} and K_{y} directions corresponds to the aspect ratio of the MRI scanning data in the K_{z} and K_{y} directions.

J. MIAO et al. "K-space reconstruction with anisotropic kernel support (KARAOKE) for ultrafast partially parallel imaging", MEDICAL PHYSICS, AIP, vol. 38, no.11, November 2011, pages 6138-6142 disclose a method of performing image reconstruction by using rectangular- and anisotropic-shaped kernels.

J. MIAO et al. "Modeling non-stationarity of kernel weights for k-space reconstruction in partially parallel imaging", MEDICAL PHYSICS, vol. 38, no. 8, August 2011, pages 4760-4773 teach to fill in missing data by using multiple kernels of different sizes.

A. Deshmane et al. "Parallel MR imaging", JOURNAL OF MAGNETIC RESONANCE IMAGING, vol. 36, no. 1, July 2012, pages 55-72 disclose a method of performing a parallel MR imaging by using a rectangular-shaped kernel.

### [Disclosure]

### [Technical Problem]

The objective of the present disclosure is to provide a new MRI parallel image reconstruction technique capable of improving both image quality and computational speed compared to the previously developed MRI parallel image reconstruction techniques.

### [Technical Solution]

The invention is set out in the appended set of claims.

### [Advantageous Effects]

The present disclosure provides the following effects. According to the present disclosure, the quality of the MRI reconstruction image as well as the computation time required for the reconstruction can be improved significantly compared to the conventional technologies by using a boomerang-shaped kernel. In particular, it can be confirmed that the present disclosure exhibits superior performance as compared with the previously developed 3D-GRAPPA, EX-3D-GRAPPA, and SK-3D-GRAPPA in terms of RMSE, which is an index of image quality, and it can also be confirmed that the present disclosure exhibits the best performance in terms of computation time as compared with the conventional technologies described above.

Further, according to the present disclosure, in the process of obtaining ACS lines, the ACS lines having the same array aspect ratios as MRI scanning data can be acquired, and then a weighting factor can be calculated on the basis of the ACS lines, which results in further improved restoration ability compared to the conventional technology.

### [BRIEF DESCRIPTION OF THE DRAWINGS]

The above and other objects, features, and advantages of the present disclosure will become more apparent to those of ordinary skill in the art by describing in detail exemplary embodiments thereof with reference to the accompanying drawings.
FIG. 1 is a view illustrating examples of an MRI image reconstruction technique according to a conventional technology.
FIG. 2 is a flowchart illustrating a three-dimensional parallel image reconstruction technique according to an embodiment of the present disclosure.
FIG. 3 is a view showing examples of MRI scanning data that can be acquired on a k-space according to an embodiment of the present disclosure.
FIG. 4 is a view provided to explain, by comparison, ACS lines acquired by the conventional technology and ACS lines acquired according to an embodiment of the present disclosure.
FIGS. 5 and 6 are views illustrating examples of kernels that can be used in the process of filling the missing data with estimation values according to an embodiment of the present disclosure.
FIG. 7 is a view conceptually illustrating how the MRI scanning data is divided into a plurality of data groups on a k-space according to an embodiment of the present disclosure.
FIG. 8 is a view conceptually illustrating a range of first and second type kernels applied to one data group according to an embodiment of the present disclosure.
FIG. 9 is a view conceptually illustrating a method of filling the missing data with estimation values using first and second type kernels according to an embodiment of the present disclosure.
FIG. 10 is a view conceptually illustrating one data group filled with the estimation values according to the method of FIG. 9.
FIG. 11 is a view conceptually illustrating the MRI scanning data divided into first and second sub-data on a k-space with reference to first and second type kernels according to an embodiment of the present disclosure.
FIGS. 12 to 14 show examples of trajectories of the first and second type kernels according to an embodiment of the present disclosure.
FIGS. 15 and 16 are graphs and a table illustrating the performance of the present disclosure compared with the conventional technologies illustrated in FIG. 1.
FIG. 17 shows MRI images acquired in the process of deriving the data of FIGS. 15 and 16 according to conventional technologies and the present disclosure.
FIG. 18 illustrates an example of the arrays of target data in the kernel according to an embodiment of the present disclosure.

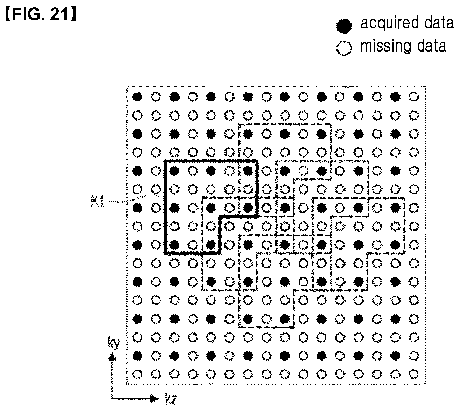

FIGS. 19 to 21 are views illustrating examples of applicable kernels and their trajectories when reduction factors R_{y} and R_{z} are each 2.

### [BEST MODE]

Hereinafter, a three-dimensional (3D) parallel image reconstruction technique according to an embodiment of the present disclosure will be described in more detail with reference to the accompanying drawings.

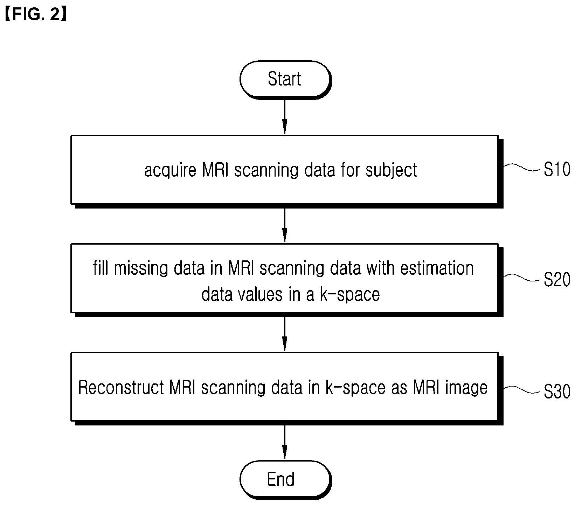

FIG. 2 is a flowchart illustrating a 3D parallel image reconstruction technique according to an embodiment of the present disclosure.

As illustrated in FIG. 2, the 3D parallel image reconstruction technique according to an embodiment of the present disclosure first involves a step of acquiring MRI scanning data for a subject (S10). The step S10 may be performed by an MRI scanning device, and the resultant MRI scanning data may be stored in a storage medium such as a memory. In this example, the MRI scanning device and the memory may be provided in a 3D parallel image reconstruction system that implements the 3D parallel image reconstruction technique according to the present embodiment, and the 3D parallel image reconstruction system may further include a computing device for performing steps S20 and S30 to be described below.

In the step S10, information is not acquired for all of the data points in the k_{y} direction (phase-encoding direction) and the k_{z} direction (partition-encoding direction) on the k-space, and instead, the information is acquired only for some data points, while information for the remaining points is not acquired in order to reduce data acquisition time.

Therefore, when viewed in the k-space, the MRI scanning data acquired at S10 is composed of acquired data that is filled with information, and missing data that does not include information.

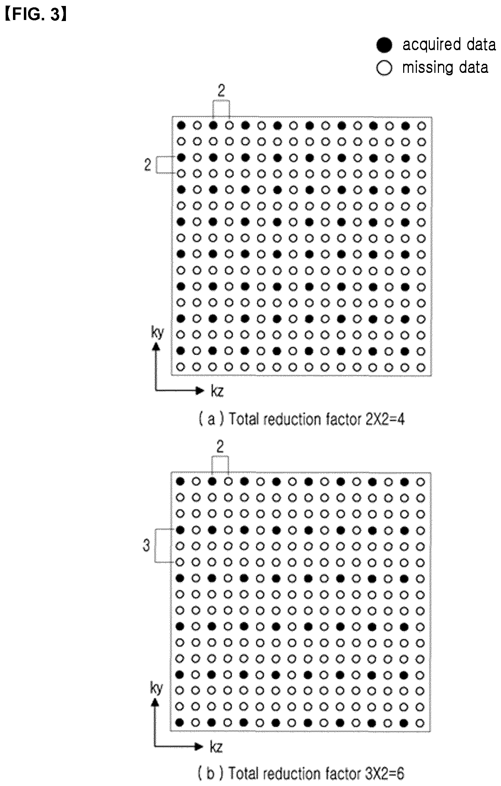

For example, as shown in FIG. 3A, the step S10 may be performed in such a manner that data is not acquired for one of a pair of adjacent data rows in the k_{y} direction, and data is not acquired for one of a pair of adjacent data columns in the k_{z} direction. For another example, as shown in FIG. 3B, the step S10 may be performed in such a manner that data is not acquired for one of three adjacent data rows in the k_{y} direction, and data is not acquired for one of a pair of adjacent data columns in the k_{z} direction.

In the step S10, a reduction factor may be used to indicate the degree of the non-acquired data in the k_{y} and k_{z} directions.

When the data is not acquired for one row of (m) adjacent data rows in the k_{y} direction, a reduction factor R_{y} in the k_{y} direction is defined as 'm', and when the data is not acquired for one of (n) adjacent data columns in the k_{z} direction, a reduction factor R_{z} in the k_{z} direction is defined as 'n'. The total reduction factor is defined as the product of m and n, *i.e*., m×n.

Accordingly, in the example of FIG. 3A, R_{y}=R_{z}=2 and the total reduction factor = 2×2=4. In addition, in the example of FIG. 3B, R_{y}=3, R_{z}=2, and the total reduction factor = 3×2=6. The total reduction factor in FIG. 3B is greater than the total reduction factor in FIG. 3A, and from this, it can be easily seen that the degree of missing data in the example of FIG. 3B is greater than that in the example of FIG. 3A.

In the step S10 of acquiring MRI scanning data, auto-calibration signal (ACS) lines are also acquired. In this example, the ACS lines are used in the process of obtaining the estimation values of the missing data in step S20, to be described later, to determine the weighting factor of the acquired data used for the estimation of certain missing data. Since the technique itself for determining the weighting factor using the ACS lines is well known, a detailed description thereof will be omitted.

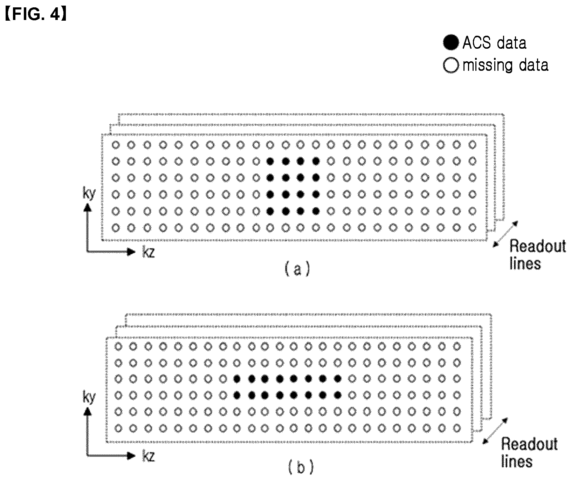

FIG. 4A shows the ACS lines according to the conventional technology, and FIG. 4B shows the ACS lines according to the present disclosure.

As shown in FIG. 4A, in the example of the conventional technology, the pattern of the array of ACS lines in k_{z} and k_{y} directions does not correspond to that of the array of MRI scanning data. That is, in the example of the conventional technology, the MRI scanning data is a 24x6 array in the k_{y} and k_{y} directions, while the ACS lines are a 4×4 array in the k_{z} and k_{y} directions, which does not correspond to the MRI scanning data.

On the other hand, as shown in FIG. 4B, in the embodiment of the conventional technology, the pattern of the array of ACS lines in k_{z} and k_{y} directions corresponds to that of the array of MRI scanning data. That is, in the embodiment of the present disclosure, the MRI scanning data is a 24×6 array in the k_{y} and k_{y} directions, and the ACS lines are an 8x2 array in the k_{z} and k_{y} directions, which corresponds to the MRI scanning data. In other words, in the present disclosure, the ACS lines are obtained so that the aspect ratio of the ACS lines in the k_{z} and k_{y} directions corresponds to the aspect ratio of the MRI scanning data in the k_{z} and k_{y} directions. As a result, improved reconstruction ability can be provided compared to the conventional technology.

As shown in FIG. 2, a step S20 of filling a plurality of missing data with estimation data values on the basis of a plurality of acquired data on a k-space is performed.

The step S20 may be performed by a computing device such as a microprocessor, and the computing device may load MRI scanning data previously stored in the storage medium to perform the step S20, or directly receive the MRI scanning data as acquired from the MRI scanning device to perform the step S20.

In the 3D parallel image reconstruction technique according to the present embodiment, a boomerang-shaped kernel different from the conventional kernels is used for performing the step S20. This will be described in more detail below.

As shown in FIG. 2, finally, step S30 is performed by Fourier-transforming the MRI scanning data filled with the additional data values to reconstruct the MRI image. The MRI image acquired in this step may be used for diagnosis of the subject.

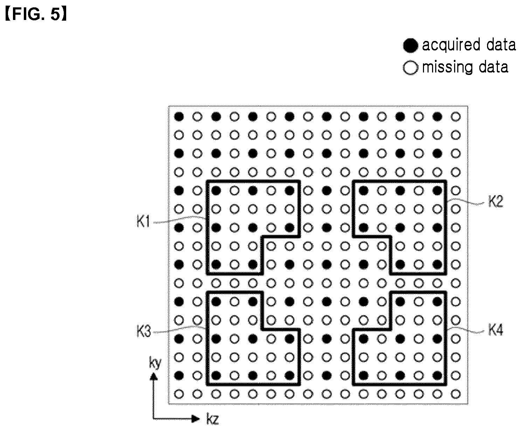

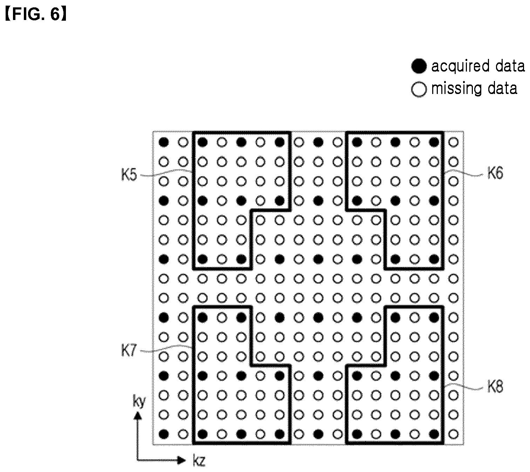

FIGS. 5 and 6 are views illustrating examples of kernels that can be used in the process of filling the missing data with estimation values according to an embodiment of the present disclosure. In this example, FIG. 5 illustrates an example where R_{y}=R_{z}=2 and the total reduction factor = 2x2=4, and FIG. 6 illustrates an example where R_{y}=3, R_{z}=2, and total the reduction factor = 3×2=6.

As described above, in the present disclosure, a boomerang-shaped kernel is used. Four kernels K1, K2, K3, and K4 shown in FIG. 5 and four kernels K5, K6, K7, and K8 shown in FIG. 6 are representative examples of the boomerang-shaped kernel.

The 'boomerang shape' as used herein is defined as a hexagonal shape with five inner angles at right angles and one inner angle at 270 degrees. For example, it can be easily understood from the shape of the first kernel K1 that it has five internal angles at right angles and one inner angle at 270 degrees.

Accordingly, as shown in FIGS. 5 and 6, the kernel that is applicable in the present disclosure may have one of a 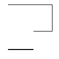 shape, a 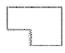 shape, a 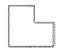 shape, and a 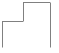 shape. In the example shown in FIG. 5, the first through fourth kernels K1, K2, K3, and K4 have a 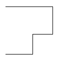 shape, a 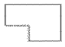 shape, a 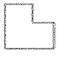 shape, and a 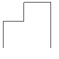 shape, respectively, and in the example shown in FIG. 6, the fifth through eighth kernels K5, K6, K7, and K8 have a 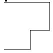 shape, a 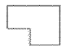 shape, a 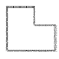 shape, and a 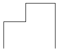 shape, respectively.

When comparing FIGS. 5 and 6, the kernels surround the same number of acquired data, i.e., eight acquired data. That is, the number of acquired data surrounded by one kernel is constant regardless of the reduction factor. However, the number of missing data surrounded by the kernel in FIG. 5 is 13, and the number of missing data surrounded by the kernel in FIG. 6 is 21, and this means that the number of missing data surrounded by the kernel varies according to the reduction factor.

Generally speaking, (A) number of acquired data and (B) number of missing data are surrounded by one kernel, and estimation values of (C) number of missing data, which are a portion of the (B) number of missing data, are calculated on the basis of the information of the (A) number of acquired data. Throughout the description, the (C) number of missing data is referred to as target data.

The number of target data is determined by the reduction factor. In the present disclosure, the number of target data per kernel is determined by 3(R_{y}×R_{z}-1).

For example, when R_{y}×R_{z}=2×2=4 as illustrated in FIG. 5, the number of target data is nine. Accordingly, 9 target data values among 13 missing data are estimated by 8 acquired data on the basis of one kernel.

For another example, when R_{y}×R_{z}=3×2=6 as illustrated in FIG. 6, the number of target data is fifteen. Accordingly, 15 target data values among 21 missing data are estimated by 8 acquired data on the basis of one kernel.

As described above, the number of target data per kernel is determined by 3(R_{y}×R_{z-1}), and the location of the target data in the kernel may be determined by taking into account not only the reduction factor, but also the type of kernel used, and the like.

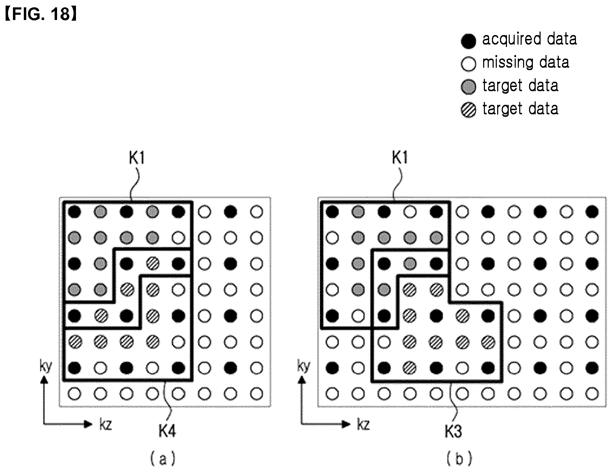

For example, when the reduction factor is R_{y}×R_{z}=2×2=4 and the first and fourth kernels K1 and K4 are used, the target data in each kernel may be determined as shown in FIG. 18A, and when the reduction factor is R_{y}×R_{z}=2×2=4 and the first and third kernels K1 and K3 are used, the target data in each kernel may be determined as shown in FIG. 18B.

The step S20 may be performed by applying one or more of the four shapes (a 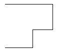 shape, a 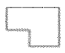 shape, a 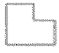 shape, and a 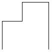 shape) described above.

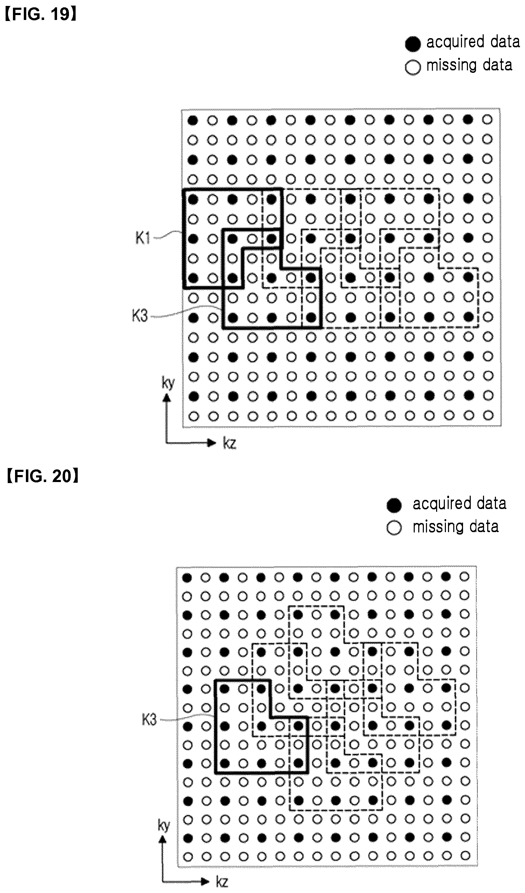

For example, when R_{y}=R_{z}=2 and the total reduction factor = 2×2=4, as shown in FIG. 19, the step S20 may be performed using the first kernel K1 of the 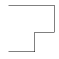 shape and the third kernel of the 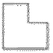 shape, and as shown in FIG. 20, the step S20 may be performed using only the third kernel K3 of the 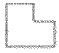 shape and the tep S20 may be performed using only the first kernel K1 of the 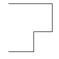 shape.

In addition, various examples may be applied, in which the step S20 may be performed using one or more of the first to fourth kernels K1, K2, K3, and K4.

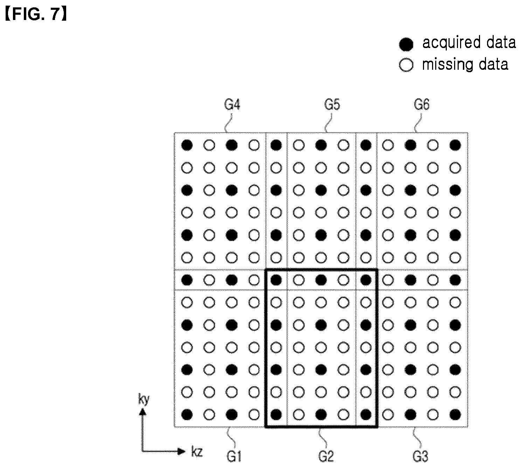

As a representative example, an example where the first kernel K1 and the second kernel K4 are used will be described with reference to FIGS. 7 to 10.

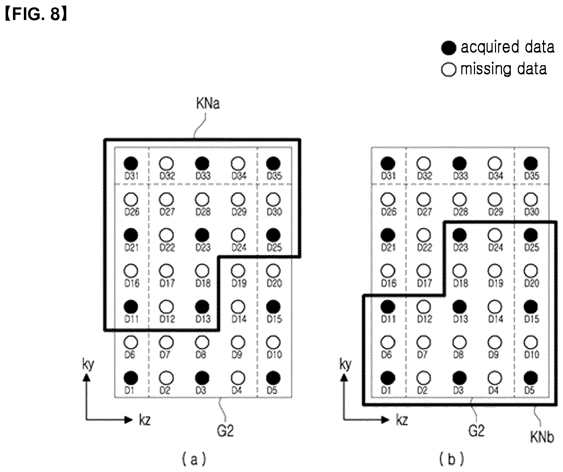

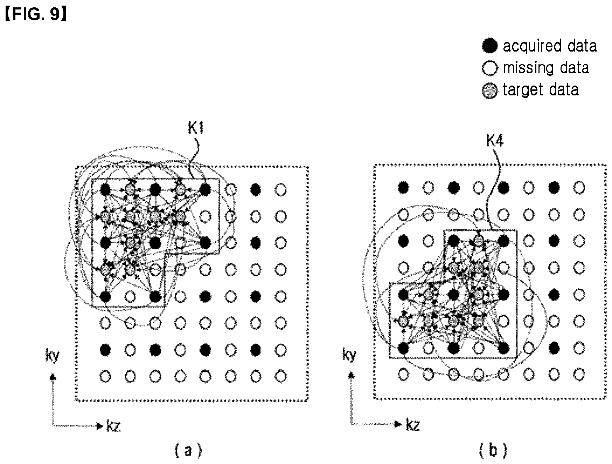

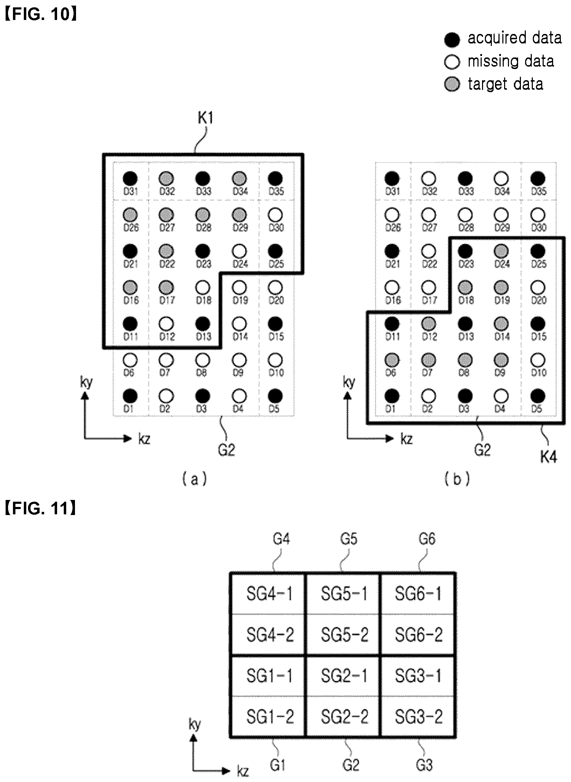

FIG. 7 is a view conceptually illustrating how the MRI scanning data is divided into a plurality of data groups on a k-space according to an embodiment of the present disclosure. FIG. 8 is a view conceptually illustrating a range of first and second type kernels applied to one data group according to an embodiment of the present disclosure. FIG. 9 is a view conceptually illustrating an example of filling the missing data with estimation values using first and second type kernels according to an embodiment of the present disclosure, and FIG. 10 is a view conceptually illustrating one data group filled with the estimation values according to the method of FIG. 9.

As shown in FIG. 7, the MRI scanning data acquired in the previous step S10 is divided into a plurality of data groups repeatedly arranged in the k_{z} direction and the k_{y} direction. For convenience of explanation, FIG. 7 shows an example in which the MRI scanning data is divided into six data groups G1 to G6.

As shown in FIG. 7, two adjacent data groups are divided from each other, but share one row or column of data.

More specifically, two data groups adjacent to each other in the k_{z} direction share one column of seven data, and two adjacent data groups in the k_{y} direction share one row of five data. For example, the data groups G1 and G2 adjacent to each other in k_{z} direction share one row of data, while the data groups G2 and G5 adjacent to each other in k_{y} direction share one row of data.

As shown in FIG. 8, illustrating the arrays of data in the data group G2, each of the data groups G1 to G6 consists of a total of 35 data arranged in a 7x5 matrix. For convenience of explanation, these 35 data are referred to as D1, D2, D5, ... , D33, D34, and D35, respectively. When it is assumed that the data closest to the origin on the k-space is specified as D1 and its coordinates are (z, y), the remaining 34 data may be specified as D2 (z+1, y), D3 (z+2, y), D4 (z+3, y), D5 (z+4, y), D6 (z, y+1), D7 (z+1, y+1), D8 (z+2, y+1), D9 (z+3, y+1), D10 (z+4, y+1), D11 (z, y+2), D12 (z+1, y+2), D13 (z+2, y+2), D14 (z+3, y+2), D15 (z+4, y+2), D16 (z, y+3), D17 (z+1, y+3), D18 (z+2, y+3), D19 (z+3, y+3), D20 (z+4, y+3), D21 (z, y+4), D22 (z+1, y+4), D23 (z+2, y+4), D24 (z+3, y+4), D25 (z+4, y+4), D26 (z, y+5), D27 (z+1, y+5), D28 (z+2, y+5), D29 (z+3, y+5), D30 (z+4, y+5), D31 (z, y+6), D32 (z+1, y+6), D33 (z+2, y+6), D34 (z+3, y+6), D35 (z+4, y+6) on the basis of the data D1 (z, y). The data D1, D2, D5, ... , D33, D34, and D35 shown in FIG. 8 are arranged based on the above.

As described above, two data groups adjacent to each other in the k_{z} direction share one column of seven data, and two adjacent data groups in the k_{y} direction share one row of five data. This will be explained with reference to an example of the data group G2 shown in FIG. 8, in which five data D31 to D35 in the top edge row of G2 are shared with the adjacent G5, and seven data D1, D6, D11, D16, D21, D26, and D31 in the left edge column of G2 are shared with G1, and seven data D5, D10, D15, D20, D25, D30, and D35 in the right edge column of the adjacent G2 are shared with the adjacent G3.

Out of the 35 data in each of the data groups G1 to G6, 12 data are acquired data, while the remaining 23 data are missing data. Referring to FIG. 8, in each of the data groups G1 to G6, D1, D3, D5, D11, D13, D15, D21, D23, D25, D31, D33, and D35 are acquired data, and the remaining 23 data are missing data.

The boomerang-shaped kernel shown in FIGS. 8 to 10 is used to fill the missing data in each of the data groups G1 to G6 described above with estimation values.

More specifically, a first type kernel K1 of a 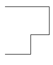 shape and a second type kernel K4 of a 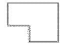 shape are used. As can be seen in FIGS. 8 to 10, the first type kernel K1 and the second type kernel K4 correspond to the first kernel K1 and the fourth kernel K4 shown in FIG. 5 described above.

Data in each of the data groups may be divided into a first sub-data group processed by the first type kernel K1 and a second sub-data group processed by the second type kernel K4.

The data group G2 shown in FIG. 8 may be divided into a first sub-data group SG2-1 (shown in FIG. 11) covered by the first type kernel K1 and a second sub-data group SG2-2 (shown in FIG. 11) covered by the second type kernel K4. As shown in FIG. 8, the first sub-data group SG2-1 includes a total of 21 data (D11, D12, D13, D16, D17, D18, D21, D22, D23, D24, D25, D26, D27, D28, D29, D30, D31, D32, D33, D34, and D35), where D12, D16, D17, D18, D22, D24, D26, D27, D28, D29, D30, D32, and D34 are missing data and the remaining data are acquired data. Meanwhile, the second sub-data group SG2-2 also includes a total of 21 data (D1, D2, D3, D4, D5, D6, D7, D8, D9, D10, D11, D12, D13, D14, D15, D18, D19, D20, D23, D24, and D25), where D2, D4, D6, D7, D8, D9, D10, D12, D14, D18, D19, D20, and D24 are missing data and the remaining data are acquired data. The first sub-data group and the second sub-data group share some data. For example, the first sub-data group SG2-1 and the second sub-data group SG2-2 of the data group G2 of FIG. 8 share D11, D12, D13, D18, D23, D24, and D25.

Referring to FIG. 11, likewise the data group G2, the other data groups G1, G3, G4, G5, and G6 may each be divided into a first sub-data group and a second sub-data group. For example, the data group G3 is divided into a first sub-data group SG3-1 and a second sub-data group SG3-2, and the data group G6 is divided into a first sub-data group SG6-1 and a second sub-data group data group SG6-2.

Referring to FIGS. 9 to 11, for each of the first and second sub-data groups, estimation data values for some of the missing data in the corresponding sub-data group are estimated on the basis of the acquired data in the corresponding sub-data group. FIG. 9A conceptually shows a data processing with the first type kernel K1 for obtaining estimation data values for some missing data in the first sub-data group, and FIG. 9B conceptually shows a data processing with the second type kernel K4 for obtaining estimation data values for some missing data in the second sub-data group.

With reference to an example of the data group G2 shown in FIG. 10, for the first sub-data group SG2-1, the estimation data values for some of the missing data D16, D17, D22, D26, D27, D28, D29, D32, and D34 are calculated through the mathematical estimation technique (e.g., an iteration technique) on the basis of the acquired data D1, D13, D21, D23, D25, D31, D33, and D35 to fill the missing data D16, D17, D22, D26, D27, D28, D29, D32, and D34. In addition, for the second sub-data group SG2-2, the estimation data values for some of the missing data D6, D7, D8, D9, D12, D14, D18, D19, and D24 are calculated through the mathematical estimation technique on the basis of the acquired data D1, D3, D5, D11, D13, D15, D23, and D25 to fill the missing data D6, D7, D8, D9, D12, D14, D18, D19, and D24.

As described above, in the embodiment of the present disclosure, eight acquired data are used to calculate the estimation data of one missing data, and in the computation process, each of the eight acquired data has a weighting factor for one missing data to be estimated, and this weighting factor may be predetermined through a technique using the auto-calibration signal (ACS) lines described above.

Meanwhile, the estimation data values for the missing data D10, D20, and D30 placed in the rightmost edge column in the data group G2 are acquired through the data estimation process in the adjacent data group G3 that shares the same edge column.

In the manner described above, estimation values of all missing data in MRI scanning data may be calculated and filled through data calculation using first and second type kernels K1 and K4 in the k-space.

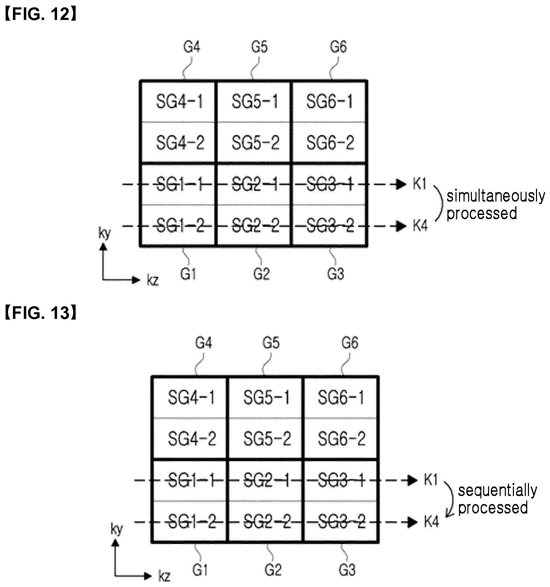

In this calculation process, a variety of methods may be applied to the trajectories of the first and second type kernels K1 and K4. FIGS. 12 to 14 show representative examples of the trajectories of the first and second type kernels.

The example shown in FIG. 12 involves a method of determining the trajectories of the first and second type kernels K1 and K4 based on the unit of data group. Of course, there may be a time difference between time points of applying the first and second type kernels in each of the data groups. When applying the trajectory of FIG. 12, the order of the data processing may be set as SG1-1, SG1-2, SG2-1, SG2-2, SG3-1, SG3-2, SG4-1, SG4-2, SG5-1, SG5-2, SG6-1, and SG6-2, for example.

The example shown in FIG. 13 involves a method of determining the trajectories of the first and second type kernels K1 and K4 with reference to the rows of the sub-data groups. When applying the trajectory of FIG. 13, the order of the data processing may be set as SG1-1, SG2-1, SG3-1, SG1-2, SG2-2, SG3-2, SG4-1, SG5-1, SG6-1, SG4-2, SG5-2, and SG6-2, for example.

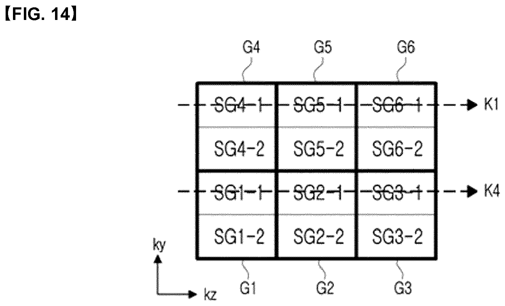

The example shown in FIG. 14 also involves a method of determining the trajectories of the first and second type kernels K1 and K4 with reference to the rows of the sub-data groups, but the method has a difference from the method illustrated in FIG. 9 in that it completes the data processing using one of the first and second type kernels K1 and K4 and then performs the data processing using the other kernel. When applying the trajectory of FIG. 14, the order of the data processing may be set as SG1-1, SG2-1, SG3-1, SG4-1, SG5-1, SG6-1, SG1-2, SG2-2, SG3-2, SG4-2, SG5-2, and SG6-2, for example.

While various methods other than those illustrated in FIGS. 12 to 14 may be applied, it is important that in either case, the first type kernel K1 and the second type kernel K4 have to pass through each of the data groups G1 to G6 once.

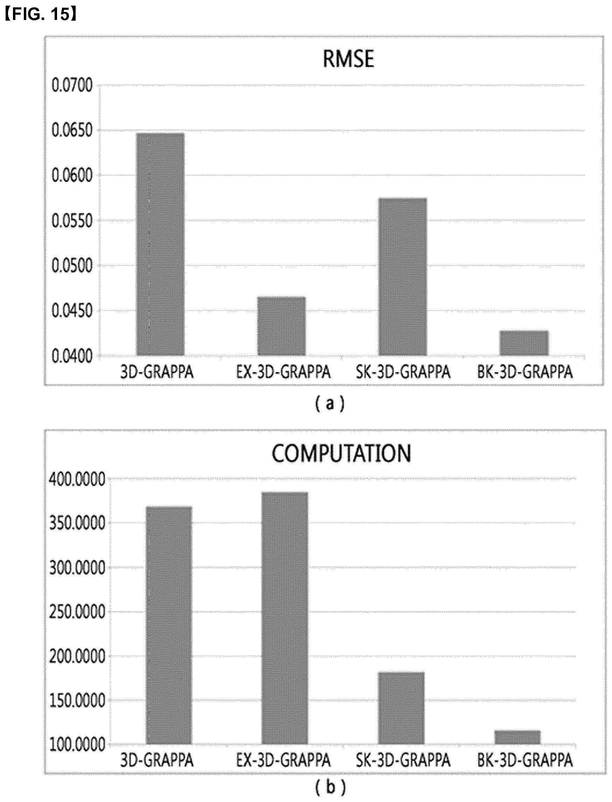

The technical effects that may be obtained through the embodiments of the present disclosure described above with reference to FIGS. 15 to 17 will be described below.

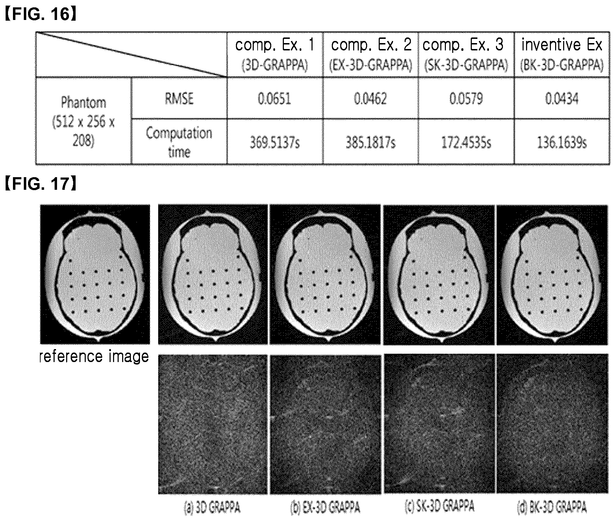

FIGS. 15 and 16 are graphs and a table illustrating the performance of the present disclosure compared with the conventional technologies illustrated in FIG. 1, and FIG. 17 shows MRI images acquired in the process of deriving the data of FIGS. 15 and 16 according to conventional technologies and the present disclosure.

To verify the performance of the present disclosure that applies a boomerang-shaped kernel, tests were conducted together with the conventional technologies shown in FIG. 1. As described above, the technique shown in FIG. 1A is 3D-GRAPPA, the technique shown in FIG. 1B is EX-3D-GRAPPA, and the technique shown in FIG. 1C is SK-3D-GRAPPA.

The techniques according to the related art and the present disclosure were applied to a common subject (phantom) under the same conditions to produce MRI images, and as a result, the acquired comparison data is shown in FIGS. 15 to 17.

In FIGS. 15 and 16, the root mean squared error (RMSE) is the standard deviation of the errors calculated by comparing the images of the Comparative Examples and the present disclosure with respect to the reference image, and the computation time is the time taken to calculate the estimation data values of the missing data. In this example, the reference image is an MRI image calculated with the data information acquired from the mode data points on the k-space in the MRI scanning process. In FIG. 17, MRI reconstructed images are shown on the top row, and the difference images between the reconstruction images and the reference image are shown on the bottom row.

As can be seen in FIGS. 15 to 17, it can be confirmed that when the present disclosure (BK-3D-GRAPPA) is applied, it exhibits the best performance in terms of RMSE, which is an index of image quality, as compared with the examples of applying the conventional technologies (3D-GRAPPA, EX-3D-GRAPPA, SK-3D-GRAPPA). In addition, as clearly shown in FIGS. 15 and 16, when the present disclosure is applied, it can be confirmed that the present disclosure exhibits the best performance in terms of computation time as compared with the conventional technologies described above.

According to the present disclosure, the quality of the MRI reconstruction image as well as the computation time required for the reconstruction can be improved significantly compared to the conventional technologies by using the kernel of the shape described above.

## Claims

1. A computer-implemented 3D GRAPPA image reconstruction method using a boomerang-shaped kernel, comprising the steps of:
a) acquiring magnetic resonance image (MRI) scanning data including a plurality of acquired data and a plurality of missing data for a subject;
b) filling the plurality of missing data with estimation data values calculated on the basis of the plurality of acquired data on a k-space; and
c) reconstructing the MRI scanning data on the k-space, which is filled with the estimation data values, as an MRI image,
wherein step b) is performed using one or more boomerang-shaped kernels;
wherein the boomerang shaped kernels have a hexagonal shape with five inner angles at right angles and one inner angle at 270 degrees;
wherein the boomerang shape includes a 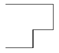 shape, a 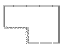 shape, a 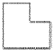 shape, and a 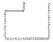 shape;
wherein, if reduction factors in a k_{y} direction and in a k_{z} direction in the k-space are R_{y} and R_{z}, respectively, a number of missing data filled with estimation data values per kernel is determined by: 3(R_{y}×R_{z-1});
wherein step b) is performed using a first type kernel of a 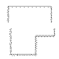 shape and a second type kernel of a 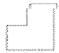 shape;
wherein when the reduction factors R_{y} and R_{z} are each 2 in step b), the MRI scanning data are divided into a plurality of data groups having data arrays of a 7x5 matrix on the k-space, wherein a pair of adjacent data groups in the k_{z} direction share one column of seven data and a pair of adjacent data groups in the k_{y} direction share one row of five data, and wherein each of the data groups is applied with one first type kernel and one second type kernel;
wherein, among the total 35 data constituting each of the data groups, by specifying the data closest to the origin on the k-space as a reference data D1 [z, y], the 35 data is specified as D1 [z, y], D2 [z+1, y], D3 [z+2, y], D4 [z+3, y], D5 [z+4, y], D6 [z, y+1], D7 [z+1, y+1], D8 [z+2, y+1], D9 [z+3, y+1], D10 [z+4, y+1], D11 [z, y+2], D12 [z+1, y+2], D13 [z+2, y+2], D14 [z+3, y+2], D15 [z+4, y+2], D16 [z, y+3], D17 [z+1, y+3], D18 [z+2, y+3], D19 [z+3, y+3], D20 [z+4, y+3], D21 [z, y+4], D22 [z+1, y+4], D23 [z+2, y+4], D24 [z+3, y+4], D25 [z+4, y+4], D26 [z, y+5], D27 [z+1, y+5], D28 [z+2, y+5], D29 [z+3, y+5], D30 [z+4, y+5], D31 [z, y+6], D32 [z+1, y+6], D33 [z+2, y+6], D34 [z+3, y+6], and D35 [z+4, y+6];
wherein the acquired data in each of the data groups are D1, D3, D5, D11, D13, D15, D21, D23, D25, D31, D33, and D35 and the remaining data are missing data;
wherein, in step b), the first type kernel covers a first sub-data group consisting of D11, D12, D13, D16, D17, D18, D21, D22, D23, D24, D25, D26, D27, D28, D29, D30, D31, D32, D33, D34, and D35, and the second type kernel covers a second sub-data group consisting of D1, D2, D3, D4, D5, D6, D7, D8, D9, D10, D11, D12, D13, D14, D15 , D18, D19, D20, D23, D24, and D25;
wherein, in step b), estimation data values for some of the missing data D16, D17, D22, D26, D27, D28, D29, D32, and D34 in the first sub-data group are calculated through an iteration technique on the basis of the acquired data D1 D13, D21, D23, D25, D31, D33, and D35 in the first sub-data group, and estimation data values for some of the missing data D6, D7, D8, D9, D12, D14, D18, D19, and D24 in the second sub-data group are calculated through an iteration technique on the basis of the acquired data D1, D3, D5, D11, D13, D15, D23, D25 in the second sub-data group,
wherein the missing data D10, D20, D30 placed in the rightmost edge column in the data group are acquired through the data estimation process in the adjacent data group that shares the same edge column.

2. The method of claim 1, wherein, in step a), auto-calibration signal ACS lines are further obtained to determine a weighting factor of the acquired data to be used for estimation of the missing data, and the value of aspect ratio of the ACS lines in the k_{y} and k_{z} directions corresponds to the value of aspect ratio as the MRI scanning data in the k_{y} and k_{z} directions.

3. A 3D GRAPPA image reconstruction system, using a boomerang-shaped kernel, comprising:
a magnetic resonance image MRI scanning device for acquiring MRI scanning data including a plurality of acquired data and a plurality of missing data for a subject; and
a computing device comprising means for carrying out the method of claim 1.

4. The system of claim 3, wherein the MRI scanning device further obtains auto-calibration signal ACS lines to determine a weighting factor of the acquired data to be used for estimation of the missing data, and the value of aspect of the ACS lines in the k_{y} and k_{z} directions corresponds to the value of array aspect ratio as the MRI scanning data in the k_{y} and k_{z} directions.

## Patentansprüche

1. Computerimplementiertes, einen bumerangförmigen Kernel verwendendes 3D-GRAPPA-Bildrekonstruktionsverfahren, das folgende Schritte umfasst:
a) Erfassen von Scandaten eines Magnetresonanzbilds (MRI), die eine Vielzahl erfasster Daten und eine Vielzahl fehlender Daten für ein Testobjekt enthalten;
b) Füllen der Vielzahl von fehlenden Daten mit Schätzdatenwerten, die auf der Basis der Vielzahl von erfassten Daten in einem k-Raum berechnet werden; und
c) Rekonstruieren der MRI-Scandaten im k-Raum, der mit den Schätzdatenwerten gefüllt ist, als ein MRI-Bild,
wobei Schritt b) unter Verwendung eines oder mehrerer bumerangförmiger Kernels ausgeführt wird;
wobei die bumerangförmigen Kernels eine sechseckige Form mit fünf Innenwinkeln in rechten Winkeln und einem Innenwinkel von 270 Grad haben;
wobei die Bumerangform enthält eine 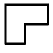 Form, eine 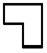 Form, eine 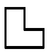 Form und eine 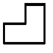 Form;
wobei, wenn Reduktionsfaktoren in einer k_{y}-Richtung und in einer k_{z}-Richtung im k-Raum R_{y} bzw. R_{z} sind, eine Anzahl von fehlenden Daten gefüllt mit Schätzdatenwerten pro Kernel bestimmt wird durch: 3(R_{y} × R_{z}-1);
wobei der Schritt b) unter Verwendung einer ersten Art Kernel einer 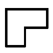 Form und einer zweiten Art Kernel einer 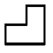 Form durchgeführt wird;
wobei, wenn die Reduktionsfaktoren R_{y} und R_{z} je 2 im Schritt b) sind, die MRI-Scandaten in eine Vielzahl von Datengruppen aufgeteilt sind, die Datenfelder einer 7x5-Matrix im k-Raum haben, wobei ein Paar benachbarter Datengruppen in der k_{z}-Richtung sich eine Spalte von sieben Daten teilen, und ein Paar benachbarter Datengruppen in der k_{y}-Richtung sich eine Zeile von fünf Daten teilen, und wobei jede der Datengruppen mit einem Kernel der ersten Art und einem Kernel der zweiten Art angewendet wird;
wobei, unter den insgesamt 35 Daten, die jede der Datengruppen bilden, durch Definieren der Daten, die dem Ursprung im k-Raum am nächsten liegen, als Bezugsdaten D1 [z, y], die 35 Daten definiert werden als D1 [z, y], D2 [z+1, y], D3 [z+2, y], D4 [z+3, y], D5 [z+4, y], D6 [z, y+1], D7 [z+1, y+1], D8 [z+2, y+1], D9 [z+3, y+1], D10 [z+4, y+1], D11 [z, y+2], D12 [z+1, y+2], D13 [z+2, y+2], D14 [z+3, y+2], D15 [z+4, y+2], D16 [z, y+3], D17 [z+1, y+3], D18 [z+2, y+3], D19 [z+3, y+3], D20 [z+4, y+3], D21 [z, y+4], D22 [z+1, y+4], D23 [z+2, y+4], D24 [z+3, y+4], D25 [z+4, y+4], D26 [z, y+5], D27 [z+1, y+5], D28 [z+2, y+5], D29 [z+3, y+5], D30 [z+4, y+5], D31 [z, y+6], D32 [z+1, y+6], D33 [z+2, y+6], D34 [z+3, y+6] und D35 [z+4, y+6]; wobei die erfassten Daten in jeder der Datengruppen D1, D3, D5, D11, D13, D15, D21, D23, D25, D31, D33 und D35 sind, und die verbleibenden Daten fehlende Daten sind;
wobei im Schritt b) der Kernel der ersten Art eine erste Subdatengruppe abdeckt, die aus D11, D12, D13, D16, D17, D18, D21, D22, D23, D24, D25, D26, D27, D28, D29, D30, D31, D32, D33, D34 und D35 besteht, und der Kernel der zweiten Art eine zweite Subdatengruppe abdeckt, die aus D1, D2, D3, D4, D5, D6, D7, D8, D9, D10, D11, D12, D13, D14, D15, D18, D19, D20, D23, D24 und D25 besteht; wobei im Schritt b) Schätzdatenwerte für einige der fehlenden Daten D16, D17, D22, D26, D27, D28, D29, D32 und D34 in der ersten Subdatengruppe mittels einer Iterationstechnik auf der Basis der erfassten Daten D1, D13, D21, D23, D25, D31, D33 und D35 in der ersten Subdatengruppe berechnet werden, und Schätzdatenwerte für einige der fehlenden Daten D6, D7, D8, D9, D12, D14, D18, D19 und D24 in der zweiten Subdatengruppe mittels einer Iterationstechnik auf der Basis der erfassten Daten D1, D3, D5, D11, D13, D15, D23, D25 in der zweiten Subdatengruppe berechnet werden,
wobei die in der am weitesten rechts liegenden Randspalte in der Datengruppe angeordneten fehlenden Daten D10, D20, D30 mittels des Datenschätzprozesses in der benachbarten Datengruppe erfasst werden, die die gleiche Randspalte mitbenutzt.

2. Verfahren nach Anspruch 1, wobei im Schritt a) weiter ACS-Autokalibrierungssignal-Linien erhalten werden, um einen Gewichtungsfaktor der erfassten Daten zu bestimmen, die zur Schätzung der fehlenden Daten zu verwenden sind, und der Wert des Aspektverhältnisses der ACS-Linien in den k_{y}- und k_{z}-Richtungen dem Wert des Aspektverhältnisses als der MRI-Scandaten in den k_{y}- und k_{z}-Richtungen entspricht.

3. 3D-GRAPPA-Bildrekonstruktionssystem unter Verwendung eines bumerangförmigen Kernels, das aufweist:
eine MRI-Magnetresonanzbild-Scanvorrichtung zur Erfassung von MRI-Scandaten, die eine Vielzahl erfasster Daten und eine Vielzahl fehlender Daten für ein Testobjekt enthalten; und
eine Rechenvorrichtung, die Einrichtungen zur Durchführung des Verfahrens nach Anspruch 1 aufweist.

4. System nach Anspruch 3, wobei die MRI-Scanvorrichtung weiter ACS-Autokalibrierungssignal-Linien erhält, um einen Gewichtungsfaktor der erfassten Daten zu bestimmen, die zur Schätzung der fehlenden Daten zu verwenden sind, und der Aspektwert der ACS-Linien in den k_{y}- und k_{z}-Richtungen dem Wert des Array-Aspektverhältnisses als der MRI-Scandaten in den k_{y}- und k_{z}-Richtungen entspricht.

## Revendications

1. Procédé de reconstruction d'image GRAPPA 3D mis en œuvre par ordinateur utilisant un noyau en forme de boomerang, comprenant les étapes suivantes :
(a) acquérir des données de balayage d'image par résonance magnétique, IRM, comprenant une pluralité de données acquises et une pluralité de données manquantes pour un sujet ;
(b) remplir la pluralité de données manquantes avec des valeurs de données d'estimation calculées sur la base de la pluralité de données acquises sur un espace k ; et
(c) reconstruire les données de balayage IRM sur l'espace k, qui est rempli avec les valeurs de données d'estimation, en tant qu'image IRM,
dans lequel l'étape b) est réalisée en utilisant un ou plusieurs noyaux en forme de boomerang ;
dans lequel les noyaux en forme de boomerang ont une forme hexagonale avec cinq angles intérieurs à angles droits et un angle intérieur à 270 degrés ;
dans lequel la forme de boomerang comprend une forme 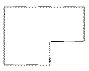 , une forme 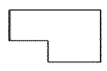 , une forme 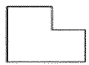 et une forme 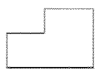 ;
dans lequel, si des facteurs de réduction dans une direction k_{y} et dans une direction k_{z} dans l'espace k sont R_{y} et R_{z}, respectivement, un nombre de données manquantes remplies avec des valeurs de données d'estimation par noyau est déterminé par : 3(R_{y}×_{Rz}-1) ;
dans lequel l'étape b) est réalisée en utilisant un noyau de premier type d'une forme 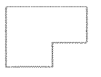 et un noyau de second type d'une forme 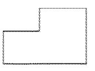 ;
dans lequel, lorsque les facteurs de réduction R_{y} et R_{z} sont chacun de 2 à l'étape b), les données de balayage IRM sont divisées en une pluralité de groupes de données ayant des réseaux de données d'une matrice 7x5 sur l'espace k, dans lequel une paire de groupes de données adjacents dans la direction k_{z} partagent une colonne de sept données et une paire de groupes de données adjacents dans la direction k_{y} partagent une rangée de cinq données, et dans lequel chacun des groupes de données est appliqué avec un noyau de premier type et un noyau de second type ;
dans lequel, parmi le total de 35 données constituant chacun des groupes de données, en spécifiant les données les plus proches de l'origine sur l'espace k comme données de référence D1 [z, y], les 35 données sont spécifiées comme D1 [z, y], D2 [z+1, y], D3 [z+2, y], D4 [z+3, y], D5 [z+4, y], D6 [z, y+1], D7 [z+1, y+1], D8 [z+2, y+1], D9 [z+3, y+1], D10 [z+4, y+1], D11 [z, y+2], D12 [z+1, y+2], D13 [z+2, y+2], D14 [z+3, y+2], D15 [z+4, y+2], D16 [z, y+3], D17 [z+1, y+3], D18 [z+2, y+3], D19 [z+3, y+3], D20 [z+4, y+3], D21 [z, y+4], D22 [z+1, y+4], D23 [z+2, y+4], D24 [z+3, y+4], D25 [z+4, y+4], D26 [z, y+5], D27 [z+1, y+5], D28 [z+2, y+5], D29 [z+3, y+5], D30 [z+4, y+5], D31 [z, y+6], D32 [z+1, y+6], D33 [z+2, y+6], D34 [z+3, y+6] et D35 [z+4, y+6] ;
dans lequel les données acquises dans chacun des groupes de données sont D1, D3, D5, D11, D13, D15, D21, D23, D25, D31, D33 et D35 et les données restantes sont des données manquantes ;
dans lequel, à l'étape b), le noyau de premier type recouvre un premier sous-groupe de données consistant en D11, D12, D13, D16, D17, D18, D21, D22, D23, D24, D25, D26, D27, D28, D29, D30, D31, D32, D33, D34 et D35, et le noyau de second type recouvre un second sous-groupe de données consistant en D1, D2, D3, D4, D5, D6, D7, D8, D9, D10, D11, D12, D13, D14, D15, D18, D19, D20, D23, D24 et D25 ;
dans lequel, à l'étape b), des valeurs de données d'estimation pour certaines des données manquantes D16, D17, D22, D26, D27, D28, D29, D32 et D34 dans le premier sous-groupe de données sont calculées par l'intermédiaire d'une technique d'itération sur la base des données acquises D1, D13, D21, D23, D25, D31, D33 et D35 dans le premier sous-groupe de données, et des valeurs de données d'estimation pour certaines des données manquantes D6, D7, D8, D9, D12, D14, D18, D19 et D24 dans le second sous-groupe de données sont calculées par l'intermédiaire d'une technique d'itération sur la base des données acquises D1, D3, D5, D11, D13, D15, D23 et D25 dans le second sous-groupe de données,
dans lequel les données manquantes D10, D20, D30 placées dans la colonne de bord la plus à droite dans le groupe de données sont acquises par l'intermédiaire du processus d'estimation de données dans le groupe de données adjacent qui partage la même colonne de bord.

2. Procédé selon la revendication 1, dans lequel, à l'étape a), des lignes de signal d'auto-étalonnage, ACS, sont en outre obtenues pour déterminer un facteur de pondération des données acquises à utiliser pour l'estimation des données manquantes, et la valeur de facteur de forme des lignes ACS dans les directions k_{y} et k_{z} correspond à la valeur de facteur de forme comme les données de balayage IRM dans les directions k_{y} et k_{z}.

3. Système de reconstruction d'image GRAPPA 3D, utilisant un noyau en forme de boomerang, comprenant :
un dispositif de balayage d'image par résonance magnétique, IRM, pour acquérir des données de balayage IRM comprenant une pluralité de données acquises et une pluralité de données manquantes pour un sujet ; et
un dispositif informatique comprenant des moyens pour réaliser le procédé selon la revendication 1.

4. Système selon la revendication 3, dans lequel le dispositif de balayage IRM obtient en outre des lignes de signal d'auto-étalonnage, ACS, pour déterminer un facteur de pondération des données acquises à utiliser pour l'estimation des données manquantes, et la valeur de facteur de forme des lignes ACS dans les directions k_{y} et k_{z} correspond à la valeur de facteur de forme de réseau comme les données de balayage IRM dans les directions k_{y} et k_{z}.
